# EUROPEAN PATENT APPLICATION

(11) **EP 2 405 461 A1**
(43) Date of publication of application: **11.01.2012**
(21) Application number: 11172562.8
(22) Date of filing: 04.07.2011
(51) Int. Cl.: H01J 37/302, H01J 37/305, G01N 1/32

(54) **Method and system for preparing a lamella**

(30) Priority: 06.07.2010 US 361538 P
(71) Applicant: Camtek Ltd., 23150 Migdal Haemek (IL)
(72) Inventor: Boguslavsky, Dimitry, 34361 Haifa (IL); Smith, Colin, 37830 D.N. Menashe (IL)
(74) Representative: Modiano, Micaela Nadia

(57) **Abstract**

A system and a method for preparing a lamella. The method may include aligning, by the manipulator, a mask (50) and a sample (21). Positioning the mask and the sample in front of an ion miller while unchanging the spatial relationship between the mask and the sample. Milling a first exposed portion of the sample until exposing a first sidewall of the lamella. Positioning the mask and the sample in front of the ion miller so that the mask masks a second masked portion of the sample. Milling, by the ion miller, the second exposed portion of the sample until exposing a second sidewall of the lamella. Removing, by the miller, matter from both sides of the lamella; and detaching the lamella from the sample.

## Description

### Related applications

This application claims priority from US provisional patent serial number 61/361,538, filing date July 6 2010, which is incorporated herein by reference.

### Field of the invention

The invention relates to methods and systems for preparing a sample for transmission electron microscopy.

### Background of the invention

Transmission electron microscopy (TEM) is a technique whereby a beam of electrons is transmitted through a thin sample, interacting with the specimen as it passes through. A high resolution image can be formed from the interaction of the electrons transmitted through the specimen. The thin sample can have a thickness of a few nano-meters.

There is a growing need to provide methods and systems for generating thin samples for Transmission electron microscopy.

### Summary

According to an embodiment of the invention a method may be provided and may include (a) receiving, by a manipulator, a mask and a sample; (b) positioning, by the manipulator, the mask and the sample in front of an imaging device so that the mask and a surface of the sample face the imaging device; (c) aligning, by the manipulator, the mask and the sample so that the mask masks a first masked portion of the sample while maintaining a first exposed portion of the sample unmasked; wherein the aligning may include obtaining images of the mask and the surface of the sample, by the imaging device; (d) positioning, by the manipulator, the mask and the sample in front of an ion miller so that the mask and the surface of the sample face the ion miller, while unchanging a spatial relationship between the mask and the sample; (e) milling, by the ion miller, the first exposed portion of the sample until exposing a first sidewall of the lamella, while masking the first masked portion by the mask; (f) positioning, by the manipulator, the mask and the sample in front of the ion miller so that the mask masks a second masked portion of the sample while maintaining a second exposed portion of the sample unmasked; wherein the second masked portion may include the lamella and a space created during the milling of the first exposed portion of the sample; (g) milling, by the ion miller, the second exposed portion of the sample until exposing a second sidewall of the lamella to provide a lamella that may include the first and second sidewalls, while masking the second masked portion by the mask; (h) removing, by the miller, matter from both sides of the lamella; and detaching the lamella from the sample.

The method may include aligning, by the manipulator, the mask and the sample so that the mask masks the second masked portion of the sample while maintaining the second exposed portion of the sample unmasked; wherein the aligning may include obtaining images of the mask and the surface of the sample, by the imaging device; and positioning, by the manipulator, the mask and the sample in front of the ion miller so that the mask and the surface of the sample face the ion miller, while unchanging the spatial relationship between the mask and the sample.

The milling of the first exposed portion of the sample until exposing the first sidewall of the lamella may be followed by rotating the mask so that the mask masks the second masked portion of the sample while maintaining the second exposed portion of the sample unmasked.

The milling of the first exposed portion of the sample until exposing the first sidewall of the lamella may be followed by rotating the sample so that the mask masks the second masked portion of the sample while maintaining the second exposed portion of the sample unmasked.

The removing of the matter from both sides of the lamella may include: (a) milling, by the ion miller, matter from a first side of the lamella while masking the lamella by the mask; (b) moving, by the manipulator at least one of the mask and the sample such as to mask the lamella by the mask while exposing matter from a second side of the lamella; and (c) milling, by the ion miller, matter from the second side of the lamella while masking the lamella by the mask.

The imaging device optical axis may be normal to a milling tool optical axis. The positioning, by the manipulator of the mask and the sample in front of the ion miller may include rotating the mask and the sample by the manipulator.

The milling may include milling while rotating a milling beam about the optical axis of the ion miller.

The distance between the first and second sidewalls does not exceed 50 nanometers.

A system for preparing a lamella may be provided. According to an embodiment of the invention the system may include a manipulator, an imaging device, an ion miller and a lamella extractor. The manipulator may be arranged to: (a) receive a mask and a sample; position the mask and the sample in front of the imaging device so that the mask and a surface of the sample face the imaging device; (b) assist in an alignment of the mask and the sample so that the mask masks a first masked portion of the sample while maintaining a first exposed portion of the sample unmasked; (c) position the mask and the sample in front of an ion miller so that the mask and the surface of the sample face the ion miller, while unchanging a spatial relationship between the mask and the sample. The ion miller may be arranged to mill the first exposed portion of the sample until exposing a first sidewall of the lamella, while masking the first masked portion by the mask. The manipulator may be further arranged to position the mask and the sample in front of the ion miller so that the mask masks a second masked portion of the sample while maintaining a second exposed portion of the sample unmasked; wherein the second masked portion may include the lamella and a space created during the milling of the first exposed portion of the sample. The ion miller may be arranged to: (a) mill the second exposed portion of the sample until exposing a second sidewall of the lamella to provide a lamella that may include the first and second sidewalls; and (b) remove matter from both sides of the lamella. The lamella extractor may be arranged to detach the lamella from the sample. The imaging device may be arranged to obtain images of the mask and the surface of the sample during the alignment of the mask and the sample.

The manipulator is further arranged to: (a) assist in the alignment of the mask and the sample so that the mask masks the second masked portion of the sample while maintaining the second exposed portion of the sample unmasked; and (b) position the mask and the sample in front of the ion miller so that the mask and the surface of the sample face the ion miller, while unchanging the spatial relationship between the mask and the sample.

The manipulator may be arranged to rotate the mask so that the mask masks the second masked portion of the sample while maintaining the second exposed portion of the sample unmasked, after the ion miller exposes the first sidewall of the lamella.

The manipulator may be arranged to rotate the sample so that the mask masks the second masked portion of the sample while maintaining the second exposed portion of the sample unmasked, after the ion miller exposes the first sidewall of the lamella.

The ion miller may be arranged to mill matter from a first side of the lamella while the mask masks the lamella; wherein the manipulator may be arranged to move at least one of the mask and the sample such as to mask the lamella by the mask while exposing matter from a second side of the lamella; and wherein the ion miller is further arranged to mill matter from the second side of the lamella while masking the lamella by the mask.

The imaging device optical axis is normal to a milling tool optical axis. The manipulator may be arranged to rotate the mask and the sample in front of the ion miller.

The ion miller may be arranged to mill the sample while rotating a milling beam about the optical axis of the ion miller.

The imaging device may be an optical device.

The imaging device may be scanning electron microscope.

The imaging device may be a combination of an optical device and a scanning electron microscope.

The distance between the first and second sidewalls of the lamella may not exceed 50 nanometers.

### Brief description of the drawings

Further details, aspects and embodiments of the invention will be described, by way of example only, with reference to the drawings. In the drawings, like reference numbers are used to identify like or functionally similar elements. Elements in the figures are illustrated for simplicity and clarity and have not necessarily been drawn to scale.

Figure 1 illustrates a portion of a system during an alignment stage according to an embodiment of the invention;

Figure 2 illustrates a portion of a system during a first milling sequence according to an embodiment of the invention;

Figure 3 illustrates a portion of a system during a second milling sequence according to an embodiment of the invention;

Figures 4A-4D illustrate the progress of the milling of a sample according to an embodiment of the invention;

Figure 5 illustrates an ion miller according to an embodiment of the invention;

Figure 6 illustrates a method according to an embodiment of the invention;

Figures 7A-7E illustrates a manipulator according to an embodiment of the invention;

Figure 8 illustrates a system according to an embodiment of the invention;

Figure 9 illustrates a method according to an embodiment of the invention; and

Figures 10A-10D illustrate air lock assemblies according to various embodiments of the invention.

### Detailed description of the drawings

The foregoing and other objects, features, and advantages of the present invention will become more apparent from the following detailed description when taken in conjunction with the accompanying drawings. In the drawings, similar reference characters denote similar elements throughout the different views.

Because the illustrated embodiments of the present invention may for the most part, be implemented using electronic components and circuits known to those skilled in the art, details will not be explained in any greater extent than that considered necessary for the understanding and appreciation of the underlying concepts of the present invention and in order not to obfuscate or distract from the teachings of the present invention.

The specification refers to rotating operations. It is noted that the rotating can be replaced by any set of movements that provides the same effect.

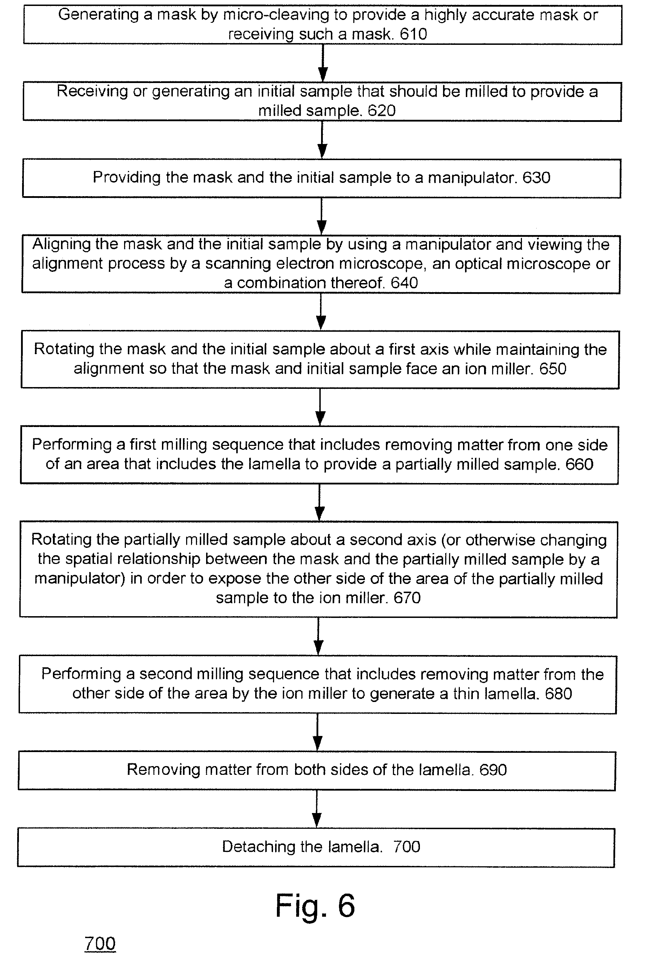

A method is provided and is illustrated in figure 6.

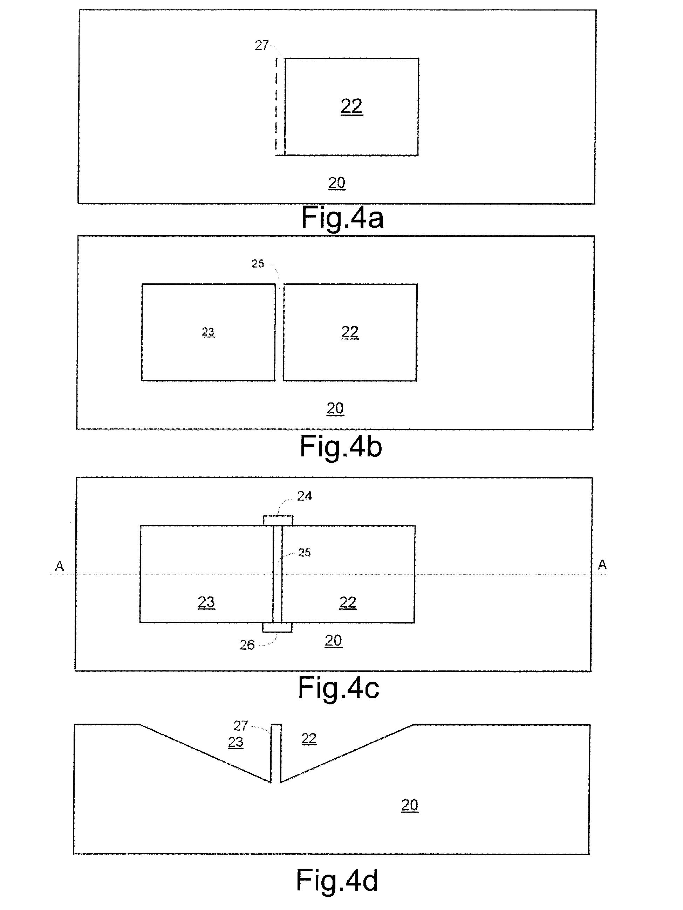

The method 600 may include:
a. Receiving or generating (stage 610) a mask, the mask may be manufactured by micro-cleaving to provide a highly accurate mask or receiving such a mask.
b. Receiving or generating (stage 620) an initial sample that should be milled to provide a milled sample.,
c. Providing (stage 630) the mask and the initial sample to a manipulator.
d. Aligning (stage 640) the mask and the initial sample by using a manipulator and viewing the alignment process by a scanning electron microscope, an optical microscope or a combination thereof.
e. Rotating (stage 650) the mask and the initial sample about a first axis while maintaining the alignment so that the mask and initial sample face an ion miller.
f. Performing (stage 660) a first milling sequence that includes removing matter (the removed matter forms a space that is denoted 22 in figures 4a-4d) from one side of an area (denoted 25 in figure 4a) that includes the lamella (denoted 27 in figure 4d) to provide a partially milled sample.
g. Rotating (stage 670) the partially milled sample about a second axis (or otherwise changing the spatial relationship between the mask and the partially milled sample by a manipulator) in order to expose the other side of the area 25 of the partially milled sample to the ion miller.
h. Performing (stage 680) a second milling sequence that includes removing matter from the other (now exposed) side of the area 25 by the ion miller 40 to generate a thin lamella 27, the removed matter forms a space that is denoted 22 in figures 4a-4d.
i. Removing (stage 690) matter from both sides of the lamella 27 and thereby forming smaller spaces 24 and 26.
j. Detaching (stage 700) the lamella 27.

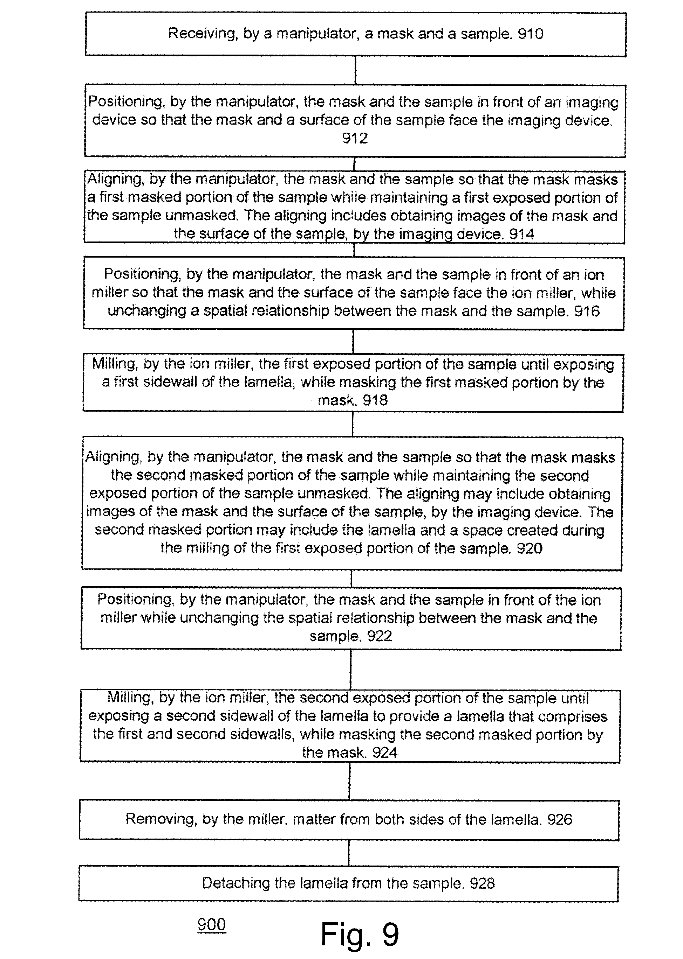

Yet according to another embodiment of the invention method 900 (of figure 9) is provided and may include the following stages:
a. Stage 910 of receiving, by a manipulator, a mask and a sample.
b. Stage 912 of positioning, by the manipulator, the mask and the sample in front of an imaging device so that the mask and a surface of the sample face the imaging device.
c. Stage 914 of aligning, by the manipulator, the mask and the sample so that the mask masks a first masked portion of the sample while maintaining a first exposed portion of the sample unmasked. The aligning includes obtaining images of the mask and the surface of the sample, by the imaging device.
d. Stage 916 of positioning, by the manipulator, the mask and the sample in front of an ion miller so that the mask and the surface of the sample face the ion miller, while unchanging a spatial relationship between the mask and the sample.
e. Stage 918 of milling, by the ion miller, the first exposed portion of the sample until exposing a first sidewall of the lamella, while masking the first masked portion by the mask.
f. Stage 920 of aligning, by the manipulator, the mask and the sample so that the mask masks the second masked portion of the sample while maintaining the second exposed portion of the sample unmasked. The aligning may include obtaining images of the mask and the surface of the sample, by the imaging device. The second masked portion may include the lamella and a space created during the milling of the first exposed portion of the sample.
g. Stage 922 of positioning, by the manipulator, the mask and the sample in front of the ion miller while unchanging the spatial relationship between the mask and the sample.
h. Stage 924 of milling, by the ion miller, the second exposed portion of the sample until exposing a second sidewall of the lamella to provide a lamella that comprises the first and second sidewalls, while masking the second masked portion by the mask.
i. Stage 926 of removing, by the miller, matter from both sides of the lamella. The removing can include:
   1. Masking the lamella while exposing one side of the lamella.
   2. Milling the matter from that side of the lamella.
   3. Masking the lamella while exposing a second side of the lamella. and
   4. Milling the matter from the second side of the lamella.
j. Stage 928 of detaching the lamella from the sample.

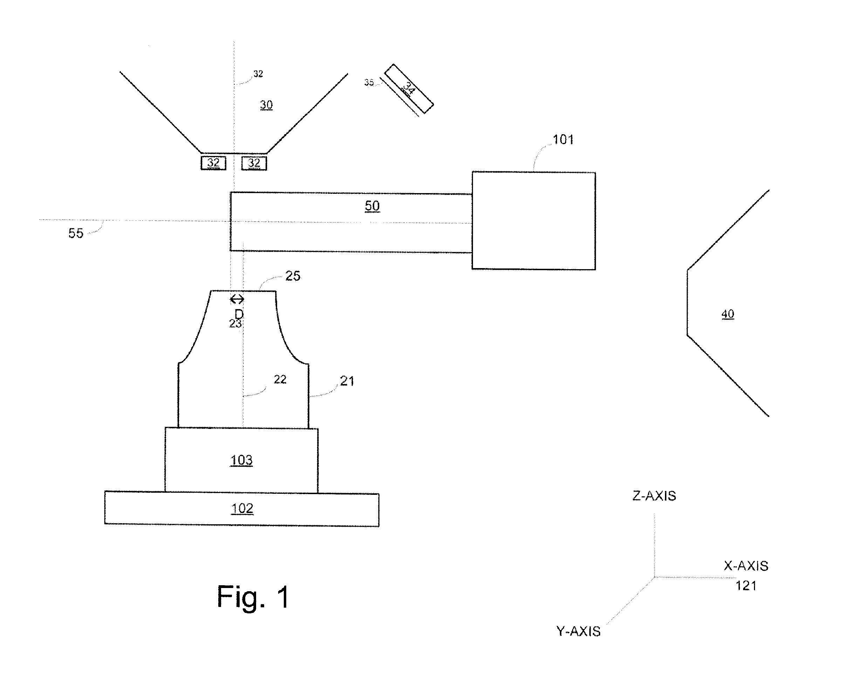

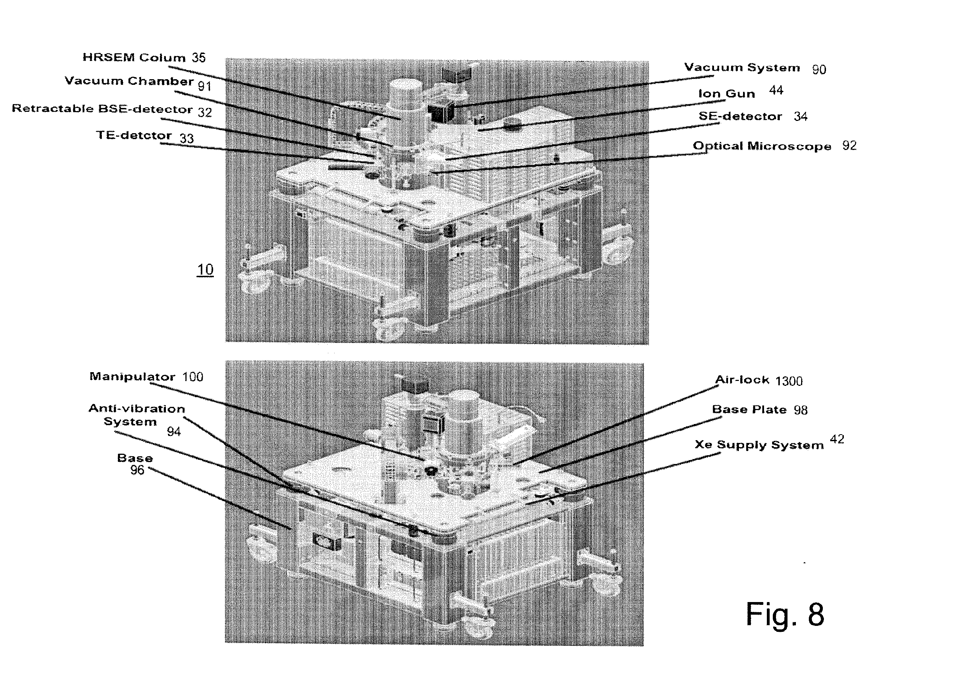

Referring to figures 1-3 and 8, the system 10 includes:
a. A manipulator 100 (that includes multiple manipulating elements such as mask angular stage 101, sample angular stage 102).
b. An imaging device such as a scanning electron microscope (including, for example, an objective lens 30, BSE detector 32, SE detector 34, TEM detector 33 as well as an electron source, electron optics and other components that may be included in a SEM column 35).
c. An ion miller 40.
d. A controller 99 for controlling the system.

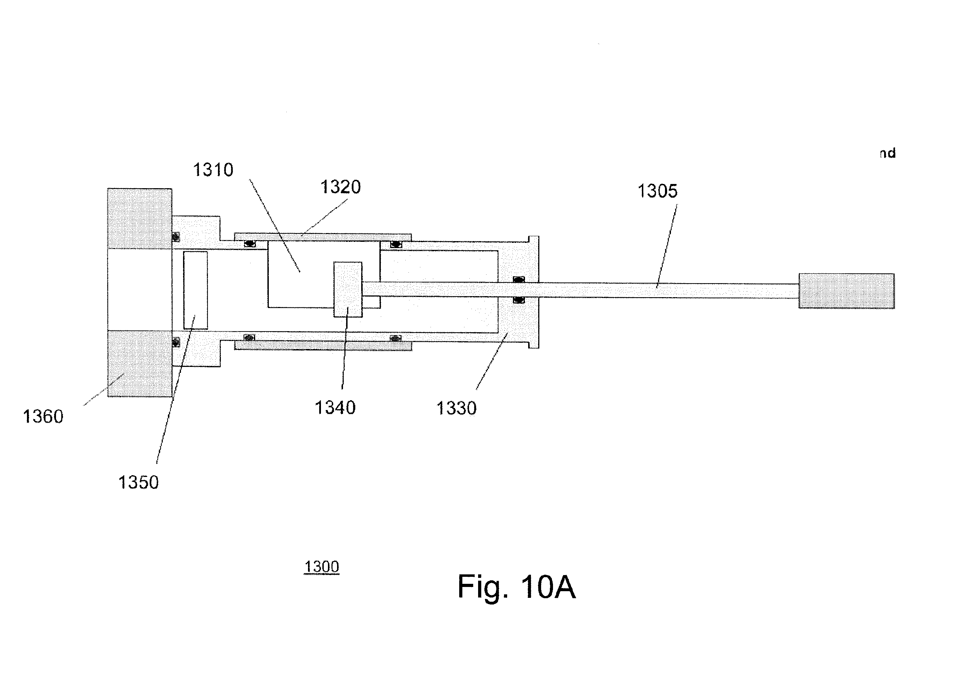

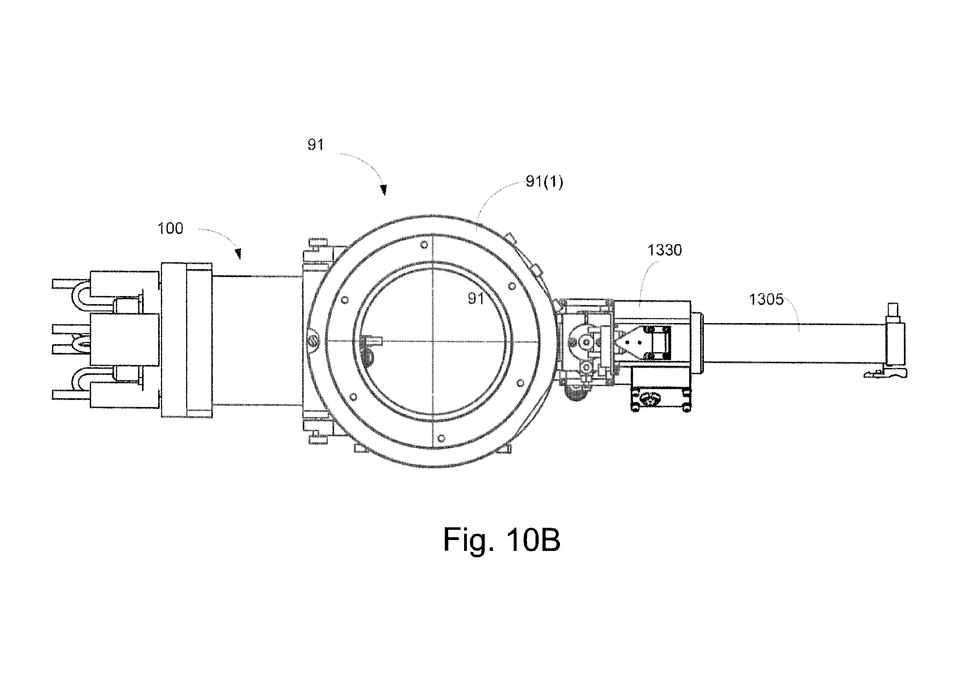

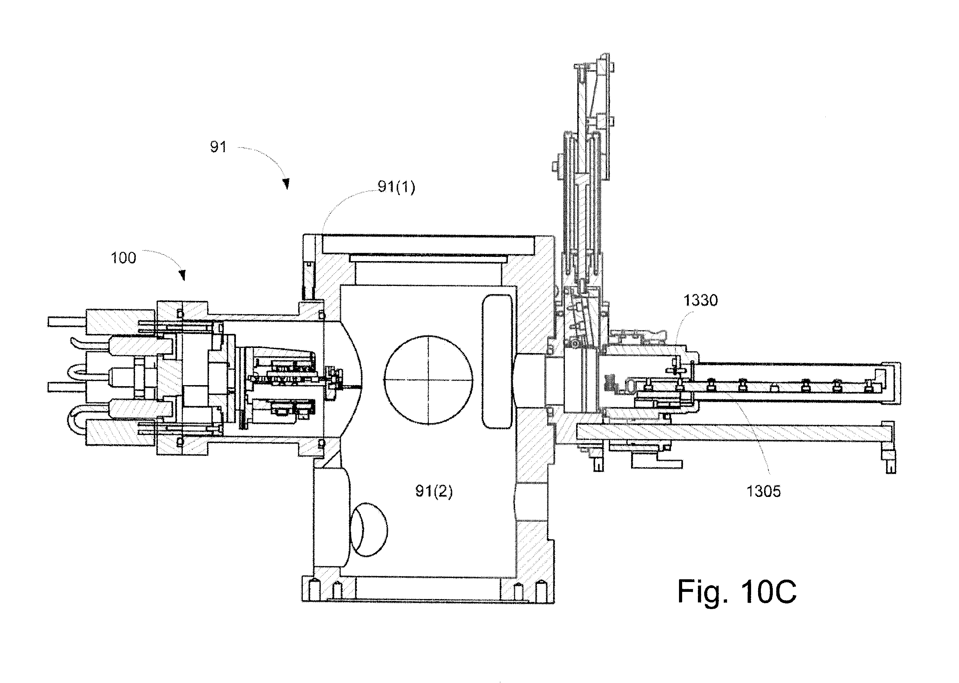

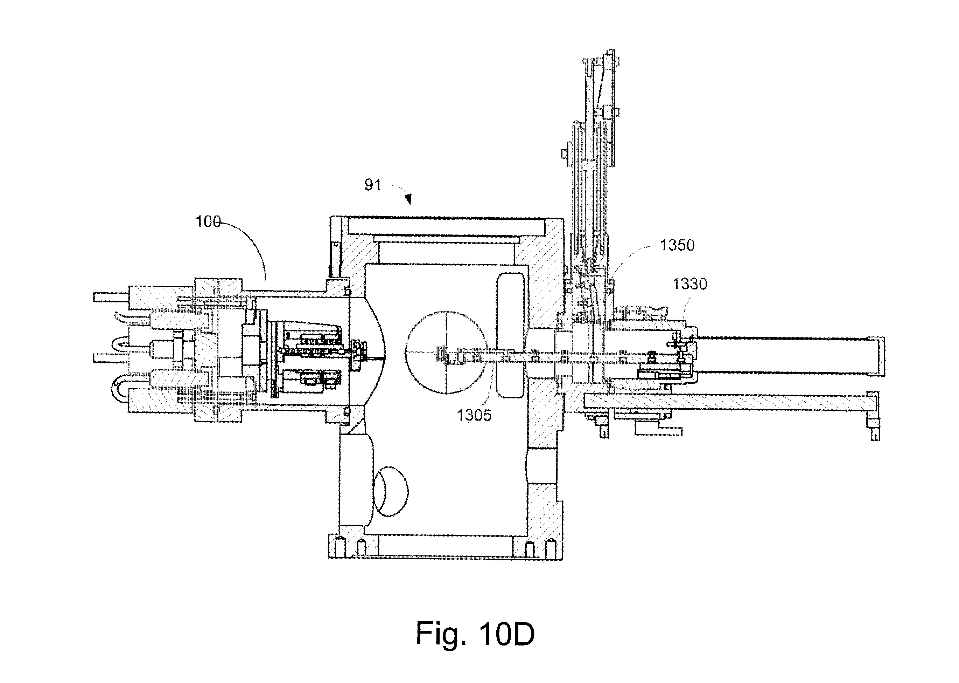

According to an embodiment of the system may also include components such as a vacuum system 90, a vacuum chamber 91, optical microscope 92, anti-vibration system 94, base 96, air-lock 1300, base plate 98. The ion beam unit 40 includes various components (some are illustrated in figures 10 and 12) such as a Xe supply unit 42 and an ion gun 44.

The system 10 may generate or receive a mask 50. The mask can be manufactured by micro-cleaving to provide a highly accurate mask. If the system generates the mask 50 then it includes a micro-cleaving unit (not shown).

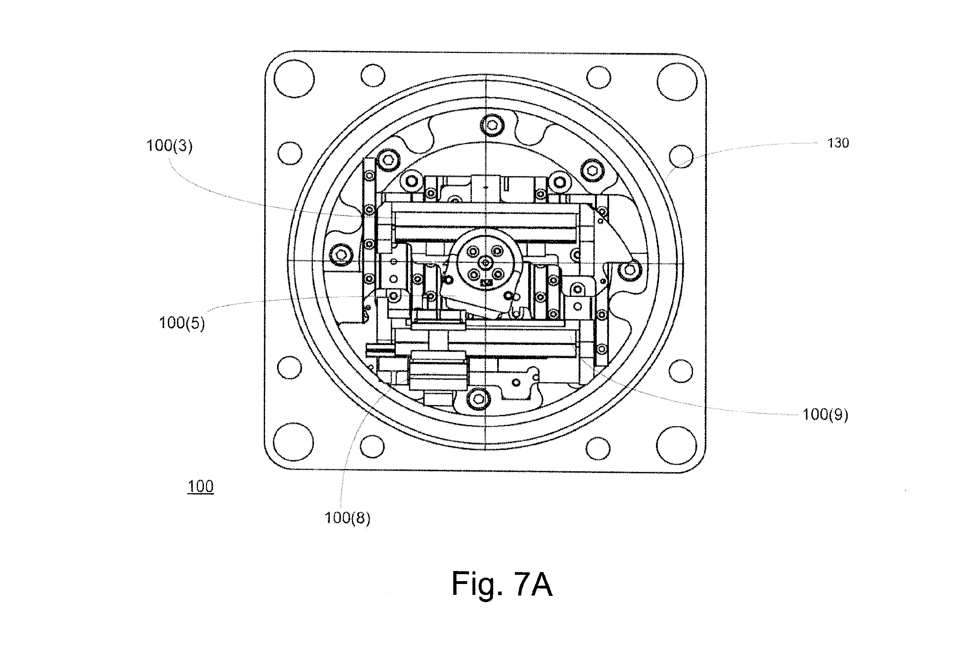

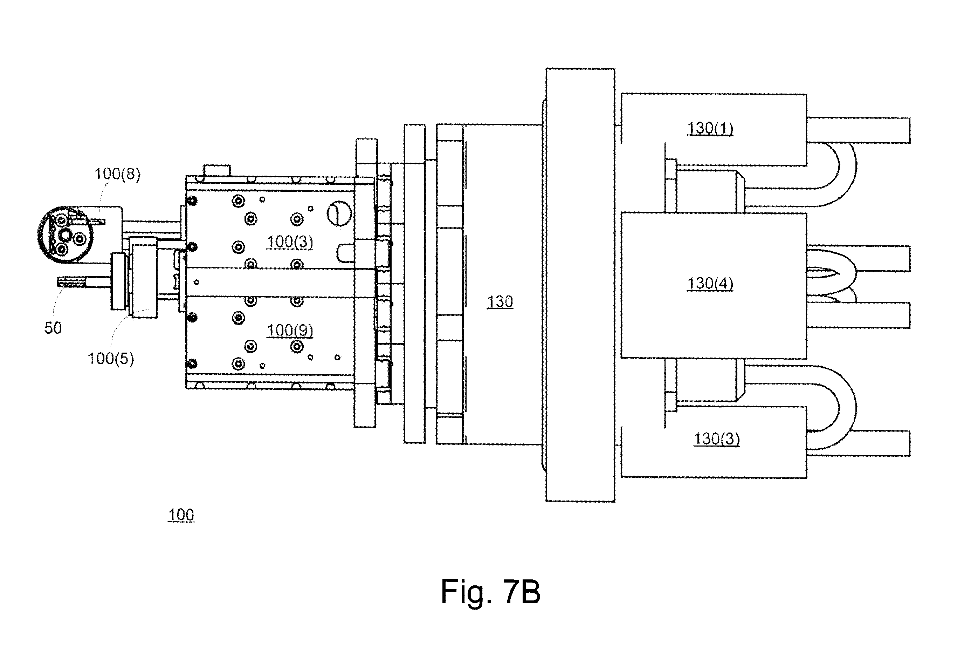

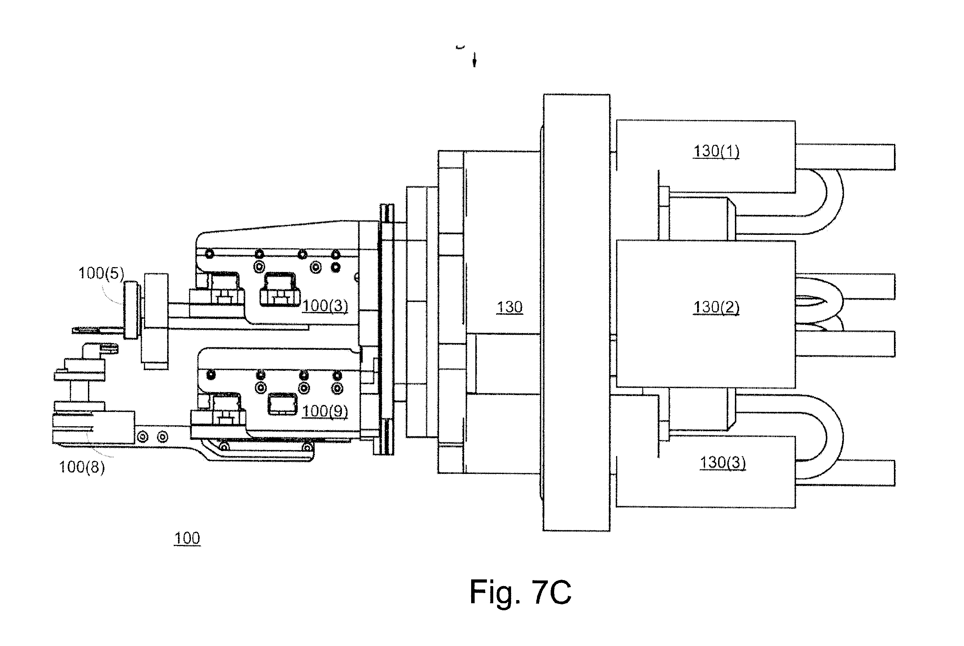

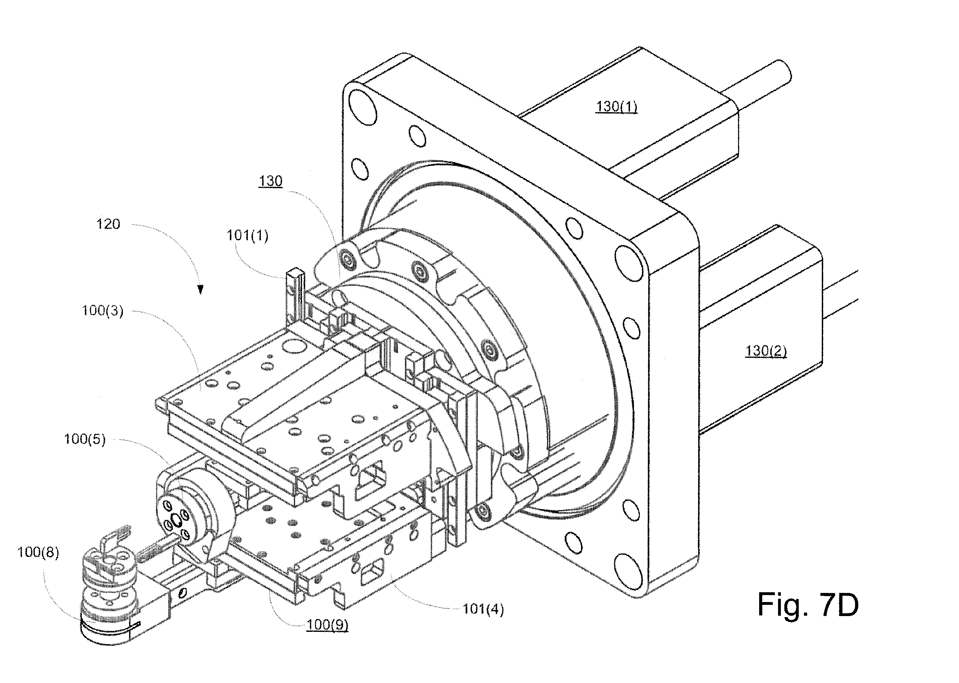

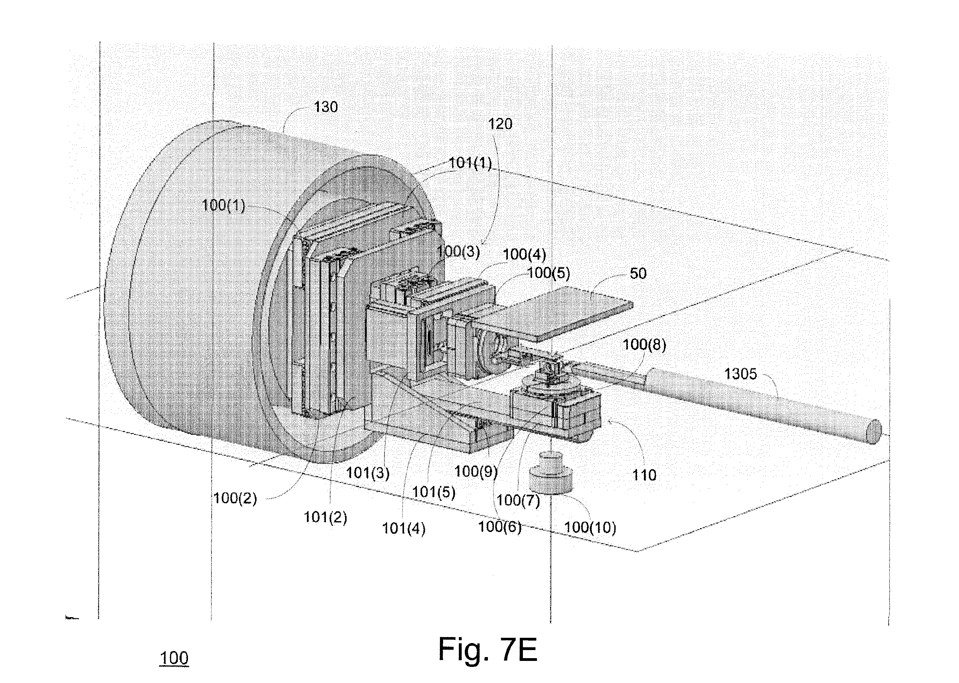

Figures 7A-7E illustrate a manipulator 100 according to various embodiment of the invention. Figure 7A is a front view of the manipulator 100, figure 7B is a top view of the manipulator 100, figure 7C is a side view of the manipulator 100 and figures 7D and 7E are three-dimensional views of various manipulators 100, all according to an embodiment of the invention.

The manipulator 100 includes two separate subunits 110 and 120 both located on a main rotating stage 130. The rotating stage 130 is separated by and powered by engines 130(1) - 130(4).

The second subunit 120 may manipulate the sample and the mask and may have X, Y, Z and θ stages. In figure 6 these stages are denoted as follows : X-stage 100(1), Y-stage 100(2), Z-stage 100(3) and θ stage 100(5).

The first subunit 110 may manipulate the sample - it may change the spatial relationship between the mask and the sample - for example by moving the mask in relation to any movement introduced by the second sub-unit 120. It is noted that each of the mask and sample can be moved by sub-units - each can move in relation to each other and not share stages such as rotating stage 130.

The first subunit 110 may have X, Y, Z and θ stages. In either one of figures 6 and 9 these stages are denoted as follows: X-stage 100(11), Y-stage (not shown), Z-stage 100(9), and θ stage 100(8).

The second subunit 120 may manipulates the mask and may also manipulate technological accessories such as mask, calibrating plate, apertures, target for deposition etc.

The first subunit 110 may receive the sample or technological accessories from a sample holder (also referred to as shuttle 103). The shuttle 103 may be transferred until it is positioned on the sample angular stage 100(8).

The stages are connected between structural elements such as plates, beams, rails, guidelines and the like denoted 101(1) - 101(5).

Referring to figure 1, the scanning electron microscope, using detector 32 and/or 34 is used to monitor an alignment process between the initial sample 21 and the mask 50.

The alignment process may include aligning the mask 50 and the initial sample 21 so that they are parallel to each other (both can be horizontal or be positioned on any other manner) and the edge of the mask 50 is positioned directly above an imaginary line that represents a desired milled edge of the initial sample 21 after being milled during a first milling sequence. This imaginary line can be located few nanometers from a center of the milled sample 21. Axis 55 illustrates that the mask is horizontal at the end of the alignment process. The distance (D 23) between a trajectory of the edge 53 of the mask 50 on the edge 25 of the initial sample 21 and the center 22 of the initial sample 31 is few nano-meters. It is about a half of the final thickness of the milled sample 21".

Once the alignment process ends the mask 50 and the initial sample 21 are rotated (by the main rotating stage 130) about an axis (about the X axis 121), while maintaining the alignment so that the mask 50 and initial sample 21 face the ion miller 40.

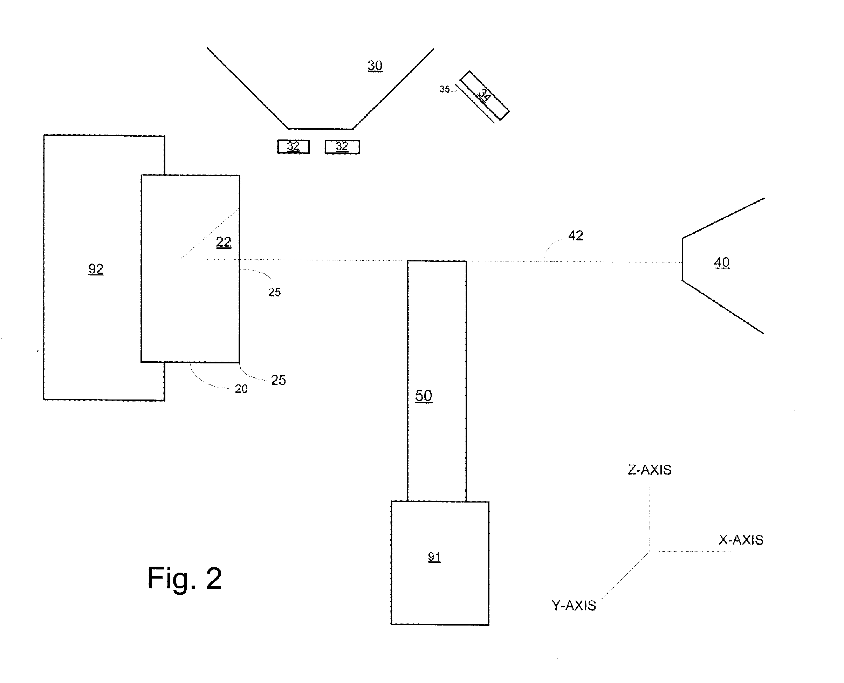

Figure 2 illustrates that the ion miller 40 can perform a first milling sequence that includes removing matter (the removed matter forms a space that is denoted 22 in figures 4a-4d) from one side of an area 25 that includes the lamella (denoted 27 in figure 4d). The first milling sequence may expose a first sidewall of the lamella.

The first milling sequence can include removing matter by a dual deflection while observing the milling by the scanning electron microscope (using detectors 32 and/or 34). The ion beam 42 of the miller 40 can be deflected within the X-Y plane, but this is not necessarily so.

After the first milling sequence ends the manipulator 100 can change the spatial relationship between the mask 50 and the partially milled sample 21' (for example- by rotating the partially milled sample 21' about a X-axis) in order to expose the other side of the area 25 of the partially milled sample that includes the final sample to the ion miller 40.

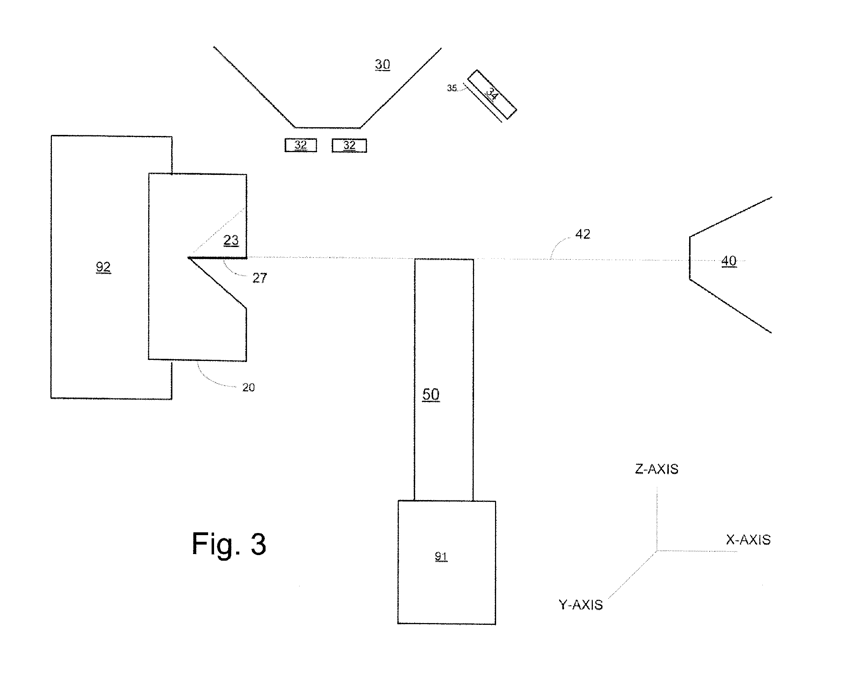

Figure 3 illustrates a second milling sequence that includes removing matter from the other (now exposed) side of the area (25) to provide a thin lamella 27, the removed matter forms a space that is denoted 23 in figures 4b-4d. The first milling sequence may expose a second sidewall of the lamella.

Thus, the first and second milling processed form a lamella that may be relatively long (in relation to its thickness) and has two sidewalls that may be parallel to each other.

After the second milling sequence two sides of the lamella are still connected to the matter that surrounds it. These sides can be disconnected by a shorter milling sequence in which fewer matter is removed. The removal can be made while using a mask or not - as the accuracy of milling of these two sides of the lamella is of less significant.

For example, if the removal is assisted by the mask then it may include: (i) changing the spatial relationship between the mask and the milled sample to expose a first area (denoted 24 in figure 3c) near one side of the lamella that is still connected to the matter that surrounds the lamella; (ii) milling the first area to detach the side of the lamella from the matter that surrounds the lamella; (iii) changing the spatial relationship between the mask and the milled sample to expose a second area near another side of the lamella that is still connected to the matter that surrounds the lamella; (iv) milling the second area (denoted 26 in figure 4c) to detach the other side of the lamella from the matter that surrounds the lamella.

The system 10 can include a retractable BSE detector, a SE detector or a combination thereof. During initial ion milling at high sputtering rate, the viewing of the sample can be accomplished by the retractable BSE detector 32 that is illustrated in figure 2 as being located beneath the pole pieces of the objective lens 30.

It is noted that the number of detectors, their location, the types of detectors and the number of parts of each detector (As well as their size and shape) can differ from the example illustrated above.

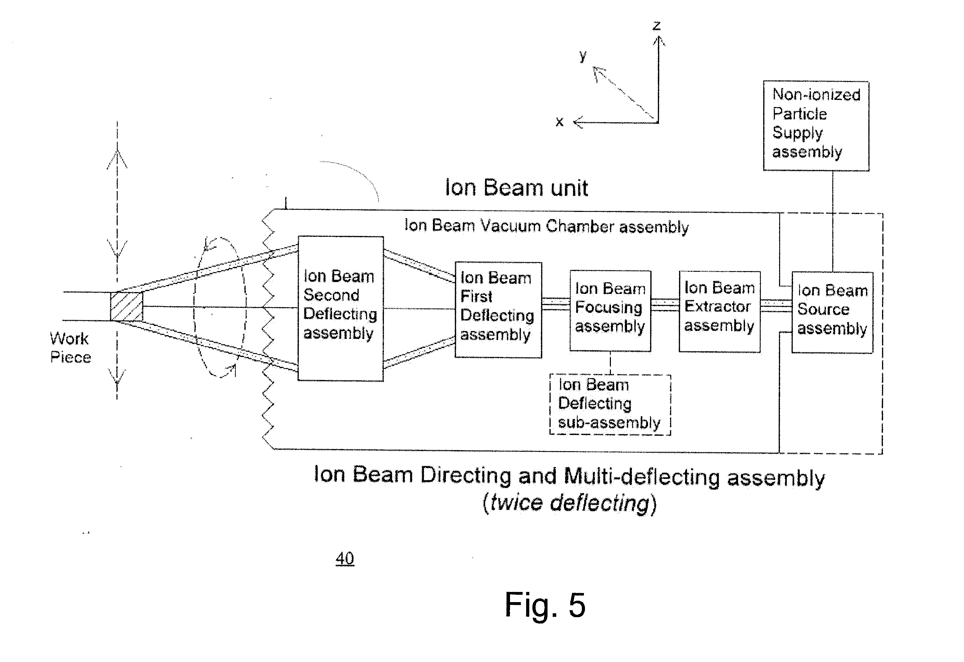

Referring to figure 5, the ion miller 40 (also referred to as ion sputtering system) can have the following capabilities and degrees of freedom: (i) Wide range of ion energy control to allow quick bulk removal to intensify the process as well as gentle milling mode to provide highest level of the final quality of a treated sample. (ii) High ion current density for short process duration. (iii) Control of ion current uniformity along beam cross section to provide uniform treatment of a sample. (iv) Variable incidence angle of the beam relatively to the sample surface to avoid selective milling of the sample surface. (v) Control of the beam shape and size to provide variety of applications and technological modes. (vi) Beam pulsating for uniformity of sample treatment. (v) Beam accurate positioning to provide specific area of a sample treatment. (vi) Beam scanning in orthogonal directions for uniformity of sample treatment. (vii) Eu-centric beam rotation around area of interest for uniformity of sample treatment.

The ion sputtering system 40 may include: (i) Duoplasmatron ion source to ignite the plasma, (ii) Beam formation module to extract and collect Xe+ ion beam from the plasma, (iii) Final optics to focus and direct ion beam toward a treated sample, (iv) Xe gas supply system to provide an automatic gas delivery of constant and specified pressure, (v) Leak-valve that provides automatic supply of metering amount of the gas into the ion source for plasma ignition and ion beam formation, and (vi) Electronics and power supplies to provide automatic control of the ion sputtering system.

A non limiting example of an ion miller is provided in US patent application publication serial number 2008/0078750A1 titled "Directed Multi-Deflected Ion Beam Milling of a Work Piece and Determining and Controlling Extent Thereof', which is incorporated herein by reference.

Referring to figures 10A-10D, the system has an air-lock 1300. Figure 10A is a schematic cross section of a air lock 1300 and wall 91(1) of a vacuum chamber 91 according to an embodiment of the invention.

Figure 10B is a top view of a air lock 1300, a vacuum chamber 91 and a manipulator 100 according to an embodiment of the invention. Figure 10B illustrates the air lock before the sample supported by the feeding rod is entered to the vacuum chamber 91.

Figure 10C is a cross sectional view of a air lock 1300, a vacuum chamber 91 and a manipulator 100 according to an embodiment of the invention. Figure 10C illustrates the air lock before the sample supported by the feeding rod is entered to the vacuum chamber 91.

Figure 10D is a cross sectional view of a air lock 1300, a vacuum chamber 91 and a manipulator 100 according to an embodiment of the invention. Figure 10D illustrates the air lock when the sample supported by the feeding rod is positioned in the vacuum chamber 91.

The air lock 1300 function is to allow loading / unloading into the vacuum chamber (denoted 91 in figure 10) numerous samples and technological accessories such as mask, calibrating plate, apertures, target for deposition etc without venting of a vacuum chamber 91.

The air lock 1300 includes:
a. A loading opening 1310 with a sliding sealing cover 1320 onto main housing 1330 for loading / unloading samples and technological accessories onto / from the feeding system (and from/onto a vacuum chamber that surrounds the manipulator).
b. A feeding system that includes a feeding rod 1305 that allows loading into the vacuum chamber 3-5 samples and technological accessories such as mask, calibrating plate, apertures, deposition target etc without additional venting of air-lock. The interface part (drum) of the feeding rod shall have numerous dove-tails for mounting on it standard shuttle carrying sample or a technological accessory. The Feeding rod 1305 can rotate about its axis and can be moved manually or by a motor.
c. A shut-off valve 1350 to prevent venting of the vacuum chamber during loading / unloading samples and technological accessories onto / from the feeding system.

The air lock 1300 is proximate to an opening in the wall 91(1) of the vacuum chamber 91 such that when the shut-off valve 1350 is opened the feeding rod 1305 can enter the vacuum chamber 91 and especially the interior space 91(2) of the vacuum chamber 91. The Air lock 1300 and especially loading opening (space) are vacuumed before the feeding rod 1305 enters the vacuum chamber. When the shut-off valve 1350 is closed the air lock 1300 is sealed in a manner that prevents gases to enter the vacuum chamber 91.

The manipulator 100 can include the following stages and these stages can be characterized by the following parameters:

Main rotating stage 130:

| | |
|---|---|
| Actuator type: | Piezo motor |
| Actuation modes: | stepping & scanning |
| Stroke: | min 120 degrees |
| Maximal speed: | 10 degrees/s |
| Maximal acceleration: | 1000 degrees/s^2 |
| Positioning accuracy with encoder closed loop: | 150 m° |
| Resolution: | 50 microns |

First sub-unit 110:

| X-axis 100(1) | |
|---|---|
| Actuator type: | Piezo motor |
| Actuation modes: | stepping & scanning |
| Stroke: | 30 mm |
| Maximal speed: | 5 mm/s |
| Maximal acceleration: | 1000 mm/s^2 |
| Positioning accuracy with encoder closed loop: | 1000 nm |
| Resolution: | 1 nm |

| Y-axis 100(2) | |
|---|---|
| Actuator type: | Piezo motor |
| Actuation modes: | stepping & scanning |
| Stroke: | 25 mm |
| Maximal speed: | 10 mm/s |
| Maximal acceleration: | 1000 mm/s^2 |
| Positioning accuracy with encoder closed loop: | 1000 nm |
| Resolution: | 1 nm |

| Z-axis 100 (3) | |
|---|---|
| Actuator type: | Piezo motor |
| Actuation modes: | stepping & scanning |
| Stroke: | 30 mm |
| Maximal speed: | 5 mm/s |
| Maximal acceleration: | 1000 mm/s^2 |
| Positioning accuracy with encoder closed loop: | 1000 nm |
| Resolution: | 1 nm |

| θ-axis (may have no thru-hole in the axis) 100(5) | |
|---|---|
| Actuator type: | Piezo motor |
| Actuation modes: | stepping & scanning |
| Stroke: | 360 degrees |
| Maximal speed: | 45 degrees/s |
| Maximal acceleration: | 1000 degrees/s^2 |
| Positioning accuracy with encoder closed loop: | 500 m° |
| Resolution: | 100 µ° |

Second sub-unit 120:

| X-axis 100(11) | |
|---|---|
| Actuator type: | Piezo motor |
| Actuation modes: | stepping & scanning |
| Stroke: | 30 mm |
| Maximal speed: | 5 mm/s |
| Maximal acceleration: | 1000 mm/s^2 |
| Positioning accuracy with encoder closed loop: | 1000 nm |
| Resolution: | 1 nm |

| Y-axis (not shown) | |
|---|---|
| Actuator type: | Piezo motor |
| Actuation modes: | stepping & scanning |
| Stroke: | 25 mm |
| Maximal speed: | 10 mm/s |
| Maximal acceleration: | 1000mm/s^2 |
| Positioning accuracy with encoder closed loop: | 1000 nm |
| Resolution: | 1 nm |

| Z-axis 100(9) | |
|---|---|
| Actuator type: | Piezo motor |
| Actuation modes: | stepping & scanning |
| Stroke: | 30 mm |
| Maximal speed: | 5 mm/s |
| Maximal acceleration: | 1000 mm/s^2 |
| Positioning accuracy with encoder closed loop: | 1000 nm |
| Resolution: | 1 nm |

| R-axis 100(8) | |
|---|---|
| Actuator type: | Piezo motor |
| Actuation modes: | stepping & scanning |
| Stroke: | 360 degrees |
| Maximal speed: | 45 degrees/s |
| Maximal acceferation: | 1000 degrees/s^2 |
| Positioning accuracy with encoder closed loop: | 250 m° |
| Resolution: | 150 µ° |

Referring to figures 1 and 5, the initial sample and the milled sample can be characterized by the following parameters:

| | |
|---|---|
| Input sample thickness | 20-30 microns |
| Milled sample thickness | 10-50 nm |
| Thickness variation in area of interest | <5nm |
| Thinned area around target feature (area of interest) | |
| Thickness <50 nm | 10 X 5 µ |
| Thickness <100 nm | 30 X 10 µ |
| Thickness <200 nm | 100 X 15 µ |
| Localization of area of interest | 5-10 nm |
| Artifacts level | |
| Amorphisation | <1 nm |
| Point defects | <1nm |
| Xe contamination | < 10⁻⁹ % |

The present invention can be practiced by employing conventional tools, methodology and components. Accordingly, the details of such tools, component and methodology are not set forth herein in detail. In the previous descriptions, numerous specific details are set forth, in order to provide a thorough understanding of the present invention. However, it should be recognized that the present invention might be practiced without resorting to the details specifically set forth.

Only exemplary embodiments of the present invention and but a few examples of its versatility are shown and described in the present disclosure. It is to be understood that the present invention is capable of use in various other combinations and environments and is capable of changes or modifications within the scope of the inventive concept as expressed herein.

## Claims

1. A method for preparing a lamella, the method comprises:
receiving, by a manipulator, a mask and a sample;
positioning, by the manipulator, the mask and the sample in front of an imaging device so that the mask and a surface of the sample face the imaging device;
aligning, by the manipulator, the mask and the sample so that the mask masks a first masked portion of the sample while maintaining a first exposed portion of the sample unmasked; wherein the aligning comprises obtaining images of the mask and the surface of the sample, by the imaging device;
positioning, by the manipulator, the mask and the sample in front of an ion miller so that the mask and the surface of the sample face the ion miller, while unchanging a spatial relationship between the mask and the sample;
milling, by the ion miller, the first exposed portion of the sample until exposing a first sidewall of the lamella, while masking the first masked portion by the mask;
positioning, by the manipulator, the mask and the sample in front of the ion miller so that the mask masks a second masked portion of the sample while maintaining a second exposed portion of the sample unmasked; wherein the second masked portion comprises the lamella and a space created during the milling of the first exposed portion of the sample;
milling, by the ion miller, the second exposed portion of the sample until exposing a second sidewall of the lamella to provide a lamella that comprises the first and second sidewalls, while masking the second masked portion by the mask;
removing, by the miller, matter from both sides of the lamella; and
detaching the lamella from the sample.

2. The method according to claim 1, comprising:
aligning, by the manipulator, the mask and the sample so that the mask masks the second masked portion of the sample while maintaining the second exposed portion of the sample unmasked; wherein the aligning comprises obtaining images of the mask and the surface of the sample, by the imaging device; and
positioning, by the manipulator, the mask and the sample in front of the ion miller so that the mask and the surface of the sample face the ion miller, while unchanging the spatial relationship between the mask and the sample.

3. The method according to claim 1, wherein the milling of the first exposed portion of the sample until exposing the first sidewall of the lamella is followed by rotating the mask so that the mask masks the second masked portion of the sample while maintaining the second exposed portion of the sample unmasked.

4. The method according to claim 1, wherein the milling of the first exposed portion of the sample until exposing the first sidewall of the lamella is followed by rotating the sample so that the mask masks the second masked portion of the sample while maintaining the second exposed portion of the sample unmasked.

5. The method according to claim 1, wherein the removing of the matter from both sides of the lamella comprises:
milling, by the ion miller, matter from a first side of the lamella while masking the lamella by the mask;
moving, by the manipulator at least one of the mask and the sample such as to mask the lamella by the mask while exposing matter from a second side of the lamella; and
milling, by the ion miller, matter from the second side of the lamella while masking the lamella by the mask.

6. The method according to claim 1, wherein an imaging device optical axis is normal to a milling tool optical axis; and wherein the positioning, by the manipulator of the mask and the sample in front of the ion miller comprises rotating the mask and the sample by the manipulator.

7. The method according to claim 1, wherein the milling comprises milling while rotating a milling beam about the optical axis of the ion miller.

8. The method according to claim 1, wherein the imaging device is an optical device.

9. The method according to claim 1, wherein the imaging device is scanning electron microscope.

10. The method according to claim 1, wherein a distance between the first and second sidewalls does not exceed 50 nanometers.

11. A system for preparing a lamella, the system comprises a manipulator, an imaging device, an ion miller and a lamella extractor;
wherein the manipulator is arranged to:
receive a mask and a sample;
position the mask and the sample in front of the imaging device so that the mask and a surface of the sample face the imaging device;
assist in an alignment of the mask and the sample so that the mask masks a first masked portion of the sample while maintaining a first exposed portion of the sample unmasked;
position the mask and the sample in front of an ion miller so that the mask and the surface of the sample face the ion miller, while unchanging a spatial relationship between the mask and the sample;
wherein the ion miller is arranged to mill the first exposed portion of the sample until exposing a first sidewall of the lamella, while masking the first masked portion by the mask;
wherein the manipulator is further arranged to:
position the mask and the sample in front of the ion miller so that the mask masks a second masked portion of the sample while maintaining a second exposed portion of the sample unmasked;
wherein the second masked portion comprises the lamella and a space created during the milling of the first exposed portion of the sample; wherein the ion miller is arranged to:
mill the second exposed portion of the sample until exposing a second sidewall of the lamella to provide a lamella that comprises the first and second sidewalls; and
remove matter from both sides of the lamella;
wherein the lamella extractor is arranged to detach the lamella from the sample; and
wherein the imaging device is arranged to obtain images of the mask and the surface of the sample during the alignment of the mask and the sample.

12. The system according to claim 11, wherein the manipulator is further arranged to:
assist in the alignment of the mask and the sample so that the mask masks the second masked portion of the sample while maintaining the second exposed portion of the sample unmasked; and
position the mask and the sample in front of the ion miller so that the mask and the surface of the sample face the ion miller, while unchanging the spatial relationship between the mask and the sample.

13. The system according to claim 11, wherein the manipulator is arranged to rotate the mask so that the mask masks the second masked portion of the sample while maintaining the second exposed portion of the sample unmasked, after the ion miller exposes the first sidewall of the lamella.

14. The system according to claim 11, wherein the manipulator is arranged to rotate the sample so that the mask masks the second masked portion of the sample while maintaining the second exposed portion of the sample unmasked, after the ion miller exposes the first sidewall of the lamella.

15. The system according to claim 11, wherein the ion miller is arranged to mill matter from a first side of the lamella while the mask masks the lamella; wherein the manipulator is arranged to move at least one of the mask and the sample such as to mask the lamella by the mask while exposing matter from a second side of the lamella; and wherein the ion miller is further arranged to mill matter from the second side of the lamella while masking the lamella by the mask.

16. The system according to claim 11, wherein an imaging device optical axis is normal to a milling tool optical axis; and wherein the manipulator is arranged to rotate the mask and the sample in front of the ion miller.

17. The system according to claim 11, wherein the ion miller is arranged to mill the sample while rotating a milling beam about the optical axis of the ion miller.

18. The system according to claim 11, wherein the imaging device is an optical device.

19. The system according to claim 11, wherein the imaging device is scanning electron microscope.

20. The system according to claim 11, wherein a distance between the first and second sidewalls does not exceed 50 nanometers.
